# EUROPEAN PATENT APPLICATION

(11) **EP 4 629 780 A1**
(43) Date of publication of application: **08.10.2025**
(21) Application number: 25160080.5
(22) Date of filing: 25.02.2025
(51) Int. Cl.: H10F 10/14, H10F 77/14, H10F 77/20, H10F 77/70

(54) **SOLAR CELL, METHOD FOR MANUFACTURING THE SAME, AND PHOTOVOLTAIC MODULE**

(30) Priority: 02.04.2024 CN 202410401318
(71) Applicant: Zhejiang Jinko Solar Co., Ltd., Haining, Zhejiang 314416 (CN)
(72) Inventor: FENG, Xiu, Haining (CN); XU, Menglei, Haining (CN); YANG, Jie, Haining (CN)
(74) Representative: Botti & Ferrari S.p.A.

(57) **Abstract**

A solar cell, a method for manufacturing the same and a photovoltaic module are provided. The solar cell includes: a semiconductor substrate, including a front surface and a rear surface opposite to the front surface, P-type conductive regions and N-type conductive regions are arranged in an alternating manner on the rear surface of the semiconductor substrate, and gap regions are each formed between adjacent P-type conductive region and N-type conductive region, a first notch region is formed by recessing along a first direction between the P-type conductive region and the gap region, a first texture structure is formed within the first notch region, the first direction is parallel to a direction from the gap region to the P-type conductive region, a second texture structure is formed within the gap region, and a shape of the second texture structure is different from a shape of the first texture structure; a first passivation layer formed over the front surface of the semiconductor substrate; and a second passivation layer formed over the rear surface of the semiconductor substrate, the second passivation layer covers the P-type conductive regions, the first notch regions, the gap regions and the N-type conductive regions.

## Description

### TECHNICAL FIELD

The present disclosure relates to the field of photovoltaic production technologies, and particularly relates to a solar cell, a method for manufacturing the same, and a photovoltaic module.

### BACKGROUND

The solar cell power generation system is a clean power generation system that generates electricity by using sunlight which can be evenly received anywhere in the world. As a power generation source, the solar cell power generation system can achieve relatively high power generation efficiency without using complex and large-scale devices. Moreover, the solar cell power generation system is expected to meet the growth in electricity requirements in the future without causing environmental damage. Therefore, public attention has been focused on the solar cell power generation system, of which the core component of the solar power generation system is the solar cell.

The interdigitated back contact (IBC) cell is a back-junction and back-contact solar cell. That is, phosphorus diffusion and boron diffusion are respectively carried out on the backlight surface of the silicon wafer to form p+ regions and n+ regions that are arranged in an interdigitated manner. In addition, both the positive and negative electrodes are also arranged in an interdigitated manner on the backlight surface of the cell. The IBC cell adopts an entire backside electrode design, which can optimize the passivation of the front surface of the cell and the light-trapping structure on the surface. In this way, the absorption and utilization of light by the solar cell can be improved, so as to obtain a relatively high photoelectric conversion efficiency. However, the light absorption efficiency on the rear surface of the IBC cell in the related art is limited, making it difficult to improve the conversion efficiency of the solar cell.

### SUMMARY

In view of this, the present disclosure provides a solar cell and a method for manufacturing the same, and a photovoltaic module, which can increase the light absorption of sunlight on the rear surface and enable the solar cell to have a good passivation effect, thereby improving the conversion efficiency of the cell.

According to a first aspect, embodiments of the present disclosure provide a solar cell, including: a semiconductor substrate including a front surface and a rear surface opposite to the front surface, P-type conductive regions and N-type conductive regions are arranged in an alternating manner on the rear surface of the semiconductor substrate, and gap regions are each formed between adjacent P-type conductive region and N-type conductive region, a first notch region is formed by recessing along a first direction between the P-type conductive region and the gap region, a first texture structure is formed within the first notch region, the first direction is parallel to a direction from the gap region to the P-type conductive region, a second texture structure is formed within the gap region, and a shape of the second texture structure is different from a shape of the first texture structure; a first passivation layer formed over the front surface of the semiconductor substrate; a second passivation layer formed over the rear surface of the semiconductor substrate, the second passivation layer covers the P-type conductive regions, the first notch regions, the gap regions and the N-type conductive regions; a first electrode that penetrates the second passivation layer to form an ohmic contact with the P-type conductive region; and a second electrode that penetrates the second passivation layer to form an ohmic contact with the N-type conductive region.

According to a second aspect, embodiments of the present disclosure provide a method for manufacturing solar cell, including the following steps: providing a semiconductor substrate, the semiconductor substrate includes a front surface and a rear surface opposite to the front surface; forming P-type conductive regions, gap regions and N-type conductive regions on the rear surface of the semiconductor substrate, the gap region is provided between adjacent P-type conductive region and N-type conductive region, a first notch region is formed by recessing along a first direction between the P-type conductive region and the gap region, a first texture structure is formed within the first notch region, the first direction is parallel to a direction from the gap region to the P-type conductive region, a second texture structure is formed within the gap region, and a shape of the second texture structure is different from a shape of the first texture structure; forming a first passivation layer over the front surface of the semiconductor substrate; forming a second passivation layer over the rear surface of the semiconductor substrate, the second passivation layer covers the P-type conductive region, the first notch regions, the gap regions and the N-type conductive region; and forming a first electrode and a second electrode on a surface of the second passivation layer.

According to a third aspect, embodiments of the present disclosure provide a photovoltaic module, including at least one cover plate, at least one encapsulation material layer and at least one solar cell string, the at least one solar cell string includes a plurality of solar cells according to the first aspect or solar cells manufactured by the method according to the second aspect.

It should be understood that the above general description and the following detailed description are only exemplary and cannot limit the present disclosure.

### BRIEF DESCRIPTION OF DRAWINGS

FIG. 1 is a structural schematic diagram of a p+ doped layer, a gap region and an n+ doped layer in the related art.
FIG. 2 is another structural schematic diagram of a p+ doped layer, a gap region and an n+ doped layer in the related art.
FIG. 3 is a structural schematic diagram of a solar cell according to one or more embodiments of the present disclosure.
FIG. 4 is an electron microscopy image of a structure between adjacent P-type conductive region and an N-type conductive region according to one or more embodiments of the present disclosure.
FIG. 5 is an electron microscopy image of a first texture structure within a first notch region according to one or more embodiments of the present disclosure.
FIG. 6 is a partial structural schematic diagram of a P-type conductive region, a first notch region, a gap region and a N-type conductive region on a rear surface of a semiconductor substrate according to one or more embodiments of the present disclosure.
FIG. 7 is a schematic diagram showing measurement of a projection length of a first sidewall on a semiconductor substrate and a projection length of a second sidewall on a plane of the semiconductor substrate according to one or more embodiments of the present disclosure.
FIG. 8 is a flow chart of a method for manufacturing solar cell according to one or more embodiments of the present disclosure.
FIG. 9 is a structural schematic diagram of a semiconductor substrate according to one or more embodiments of the present disclosure.
FIG. 10 is a structural schematic diagram of a rear surface of a semiconductor substrate after a first diffusion treatment according to one or more embodiments of the present disclosure.
FIG. 11 is a structural schematic diagram of a structure obtained by performing a first local laser treatment and a first etching treatment on a first pre-treatment region according to one or more embodiments of the present disclosure.
FIG. 12 is a structural schematic diagram of a structure obtained by performing a second diffusion treatment on a rear surface of a semiconductor substrate according to one or more embodiments of the present disclosure.
FIG. 13 is a structural schematic diagram of a structure after performing a second local laser treatment according to one or more embodiments of the present disclosure.
FIG. 14 is a structural schematic diagram of a structure after performing a second etching treatment according to one or more embodiments of the present disclosure.
FIG. 15 is a structural schematic diagram of a first passivation layer formed on a front surface of a semiconductor substrate and a second passivation layer formed on a rear surface of the semiconductor substrate according to one or more embodiments of the present disclosure; and
FIG. 16 is a structural schematic diagram of a photovoltaic module according to one or more embodiments of the present disclosure.

The drawings here are incorporated into the specification and constitute a part of this specification, showing the embodiments in line with the present disclosure and are used together with the specification to explain the principles of the present disclosure.

### DESCRIPTION OF EMBODIMENTS

In order to make the purpose, technical solutions and advantages of the present disclosure clearer, the present disclosure will be further illustrated in combination with the drawings and embodiments. It should be understood that the specific embodiments described herein are only used to explain the present disclosure and are not intended to provide any limitation.

In the description of the present disclosure, unless otherwise clearly stipulated and defined, the terms "first" and "second" are only used for descriptive purposes and shall not be understood as indicating or implying relative importance. Unless otherwise specified or explained, the term "plurality" refers to two or more. Terms such as "connection" and "fixation" should be understood in a broad sense. For example, "connection" may be a fixed connection, a detachable connection, an integral connection, or an electrical connection. "Connection" may also be directly connected or indirectly connected through an intermediate medium. For those of ordinary skill in the art, the specific meanings of the above terms in the present disclosure can be understood according to specific circumstances.

It should be noted that the orientation terms such as "above", "below", "left" and "right" described in the embodiments of the present disclosure are described from the perspective shown in the drawings and should not be understood as limitations on the embodiments of the present disclosure. In addition, in the context, it should also be understood that when it is mentioned that one element is connected "above" or "below" another element, it may not only be directly connected "above" or "below" another element, but also indirectly connected "above" or "below" another element through an intermediate element.

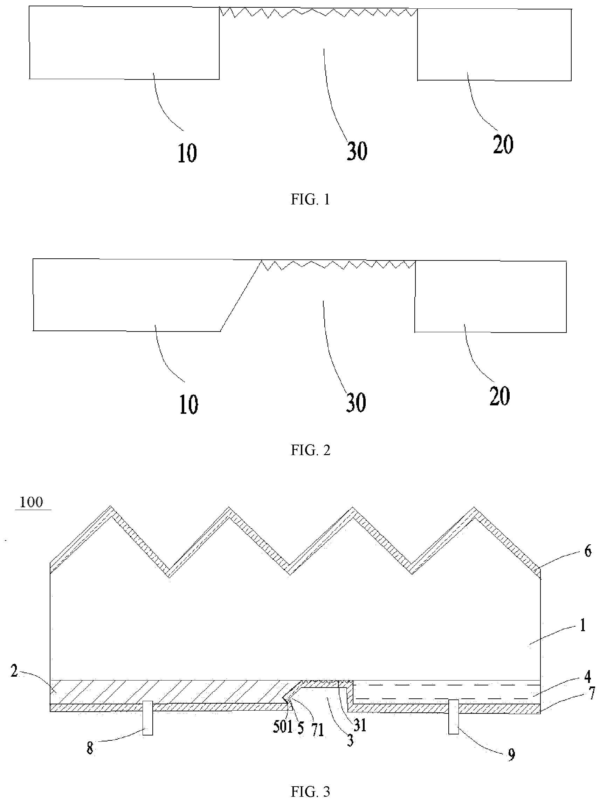

In the related technologies, during the manufacturing process of the IBC cell, the rear surface process involves forming p+ regions and n+ regions that are arranged in an interdigitated manner through phosphorus diffusion and boron diffusion. For example, boron diffusion is first carried out on the rear surface of the silicon substrate to form an n+ doped layer, and then part of the n+ doped layer is removed by means of laser. Phosphorus diffusion is carried out in the area where the n+ doped layer has been removed to form a p+ doped layer, and then etching and acid washing treatments are performed so that a gap region with a pyramidal structure is formed between the n+ doped layer and the p+ doped layer. The region between the p+ region and the gap region on the rear surface of the solar cell in the related art often fails to bring efficiency gains to the solar cell. FIG. 1 shows a structural schematic diagram of the p+ doped layer 10, the gap region 30 and the n+ doped layer 20 in the related art, and the area between the p+ doped layer 10 and the gap region 30 is in a "step" shape. FIG. 2 shows a structural schematic diagram of the p+ doped layer 10, the gap region 30 and the n+ doped layer 20 in the related art, and the area between the p+ doped layer 10 and the gap region 30 is in a "slope" shape. The above morphologies between the p+ doped layer 10 and the gap region 30 cannot make good use of sunlight, resulting in a relatively low photoelectric conversion efficiency of the solar cell.

In view of this, embodiments of the present disclosure provides a solar cell 100. FIG. 3 is a structural schematic diagram of the solar cell 100 of the present disclosure. The solar cell 100 includes: a semiconductor substrate 1 including a front surface and a rear surface that are oppositely arranged, P-type conductive regions 2 and N-type conductive regions 4 are arranged in an alternating manner on the rear surface of the semiconductor substrate 1; a first passivation layer 6 formed on the front surface of the semiconductor substrate 1; a second passivation layer 7 formed on the rear surface of the semiconductor substrate 1; a first electrode 8 that penetrates the second passivation layer 7 to form an ohmic contact (i.e., electrically contact) with the P-type conductive regions 2; and a second electrode 9 that penetrates the second passivation layer 7 to form an ohmic contact (i.e., electrically contact) with the N-type conductive regions 4. A gap region 3 is provided between adjacent P-type conductive region 2 and N-type conductive region 4. A first notch region 5 is formed by recessing between the P-type conductive region 2 and the gap region 3 along a first direction. A first texture structure 501 is formed within the first notch region 5. The first direction is parallel to a direction from the gap region 3 pointing to the P-type conductive regions 2. A second texture structure 31 is formed within the gap region 3, and a shape of the second texture structure 31 is different from a shape of the first texture structure 501. The second passivation layer 7 covers the P-type conductive regions 2, the first notch region 5, the gap region 3 and the N-type conductive regions 4.

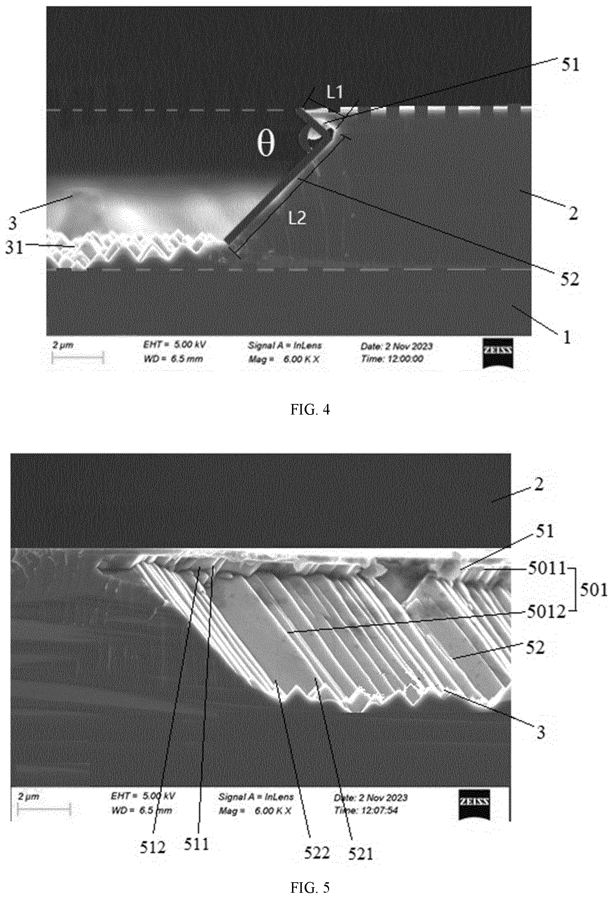

In some embodiments of the present disclosure, a first notch region 5 recessed along the first direction can be formed in the region between the P-type conductive region 2 and the gap region 3 on the rear surface of the semiconductor substrate 1. The first notch region 5 recessed along the first direction can increase the effective area for light absorption of the solar cell, thereby improving the light utilization efficiency of the solar cell and solving the problem that a "step " or "slope " shape region between the P-type conductive region 2 and the gap region 3 on the rear surface of the solar cell in the related art fails to bring efficiency gains to the solar cell. The shape of the first texture structure 501 in the first notch region 5 is different from that of the second texture structure 31 in the gap region 3. Referring to FIG. 4 and FIG. 5. FIG. 4 shows an electron microscopy image of a structure between a P-type conductive region 2 and an N-type conductive region 4, and FIG. 5 shows an electron microscopy image of a first texture structure 501 formed within the first notch region 5. The first texture structure 501 has an excellent light-trapping effect and can increase the surface area of the rear surface of the semiconductor substrate 1, thereby increasing the light absorption of sunlight on the back surface and reducing the reflection of sunlight on the back surface. Moreover, the long-wavelength light passing through the semiconductor substrate 1 from the front surface of the solar cell can also be absorbed by the first texture structure 501, further increasing the overall light absorption efficiency of the solar cell. In addition, it will not affect the passivation effect of the region between the P-type conductive region 2 and the gap region 3, thereby improving the photoelectric conversion efficiency of the solar cell.

It should be noted that the semiconductor substrate 1 generally has a front surface and a rear surface. The front surface of the semiconductor substrate 1 may refer to the light-receiving surface, that is, the surface that receives the sunlight irradiation. The rear surface of the semiconductor substrate 1 refers to the surface opposite to the front surface.

In some embodiments, the "texture structure" refers to a structure of micro-nano size that may cause light to scatter or reflect to increase light absorption.

In some embodiments, the second texture structure 31 within the gap region 3 usually has a pyramidal shape. The first texture structure 501 in some embodiments of the present disclosure has a non-pyramidal shape. The shape of the first texture structure 501 includes at least one of prismatic, pyramidal and pencil-like shapes. In the related art, a pyramidal structure is usually formed by texturing. The pyramid structure has a single shape and a relatively large base area, and has a tip structure at the top. When it is provided on the rear surface of the semiconductor substrate 1, the reflection effect of light on the back surface is average, and it is not conducive to the deposition of subsequent film layers. Compared with the texture structure with a pyramidal shape, the shape of the first texture structure 501 has a larger surface area and can utilize more sunlight.

In some embodiments, the P-type conductive region 2 refers to the region formed by highly doped P-type semiconductor materials, and the N-type conductive region 4 refers to the region formed by highly doped N-type semiconductor materials. The P-type conductive regions 2 and the N-type conductive regions 4 are distributed in an interdigitated manner on the rear surface of the semiconductor substrate 1, and are mainly used to separate and collect current carriers. The P-type conductive regions 2 are used to collect holes, and the N-type conductive regions 4 are used to collect electrons. Then, the collected carriers are respectively transferred to the electrodes on the rear surface of the semiconductor substrate 1 to form a path with the external load. Therefore, the P-type conductive regions 2 and the N-type conductive regions 4 cannot be in direct contact. Otherwise, the collected carriers will directly contact the rear surface of the semiconductor substrate 1 to form a short circuit, resulting in that the carriers are unable to be effectively collected. Therefore, a gap region 3 with a "groove shape" is usually formed between the P-type conductive region 2 and the N-type conductive region 4. There is a certain height difference between the gap region 3 and the P-type conductive region 2, so that a notch region is formed between the gap region 3 and the P-type conductive region 2. There may also be a certain height difference between the gap region 3 and the N-type conductive region 4, so that a notch region is also formed between the gap region 3 and the N-type conductive region 4. In the solar cell of the present disclosure, the morphologies and structures of the notch regions at the above two different positions are different. For example, there is a first notch region 5 between the P-type conductive region 2 and the gap region 3. The first notch region 5 is recessed along the direction from the gap region 3 pointing to the P-type conductive region 2. There is a first texture structure 501 formed within the first notch region 5, which is used to improve the light absorption capacity of the solar cell and further improve the photoelectric conversion efficiency. There is a third notch region (the third notch region is not shown in the drawings) formed between the N-type conductive region 4 and the gap region 3. The third notch region is usually in a "step" or "slope" shape. There is also a texture structure formed within the third notch region, and the texture structure is in a "step" or "slope" shape.

**In** some embodiments, the semiconductor substrate 1 is an N-type crystalline silicon substrate (or silicon wafer), and it may also be a P-type crystalline silicon substrate (silicon wafer). The crystalline silicon substrate is, for example, one of a polycrystalline silicon substrate, a monocrystalline silicon substrate, a microcrystalline silicon substrate or a silicon carbide substrate. Embodiments of the present disclosure do not limit the specific type of the semiconductor substrate 1. When the semiconductor substrate 1 is an N-type substrate, the doped elements may be Group V elements such as phosphorus (P), arsenic (As), tellurium (Te), etc. The N-type semiconductor substrate 1 forms a PN junction with the P-type conductive region 2, and the N-type semiconductor substrate 1 and the N-type conductive region 4 form an NN+ high-low junction. When the semiconductor substrate 1 is a P-type substrate, the doped elements may be Group III elements such as boron (B), aluminium (Al), gallium (Ga), etc. The P-type semiconductor substrate 1 forms a PN junction with the N-type conductive region 4, and the P-type semiconductor substrate 1 and the P-type conductive region 2 form a PP+ high-low junction.

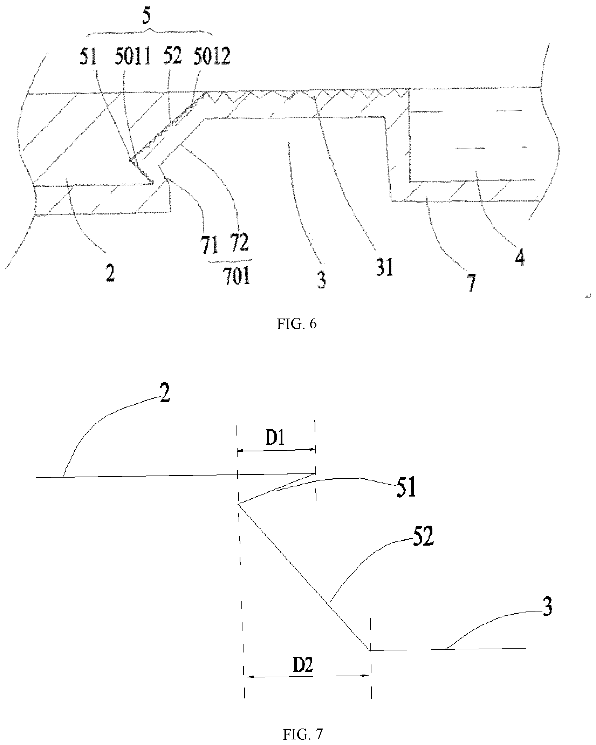

In some embodiments, referring to FIG. 4 and FIG. 6, FIG. 6 shows a partial structural schematic diagram of a P-type conductive region, a first notch region, a gap region and a N-type conductive region on a rear surface of a semiconductor substrate. The first notch region 5 has a first sidewall 51 and a second sidewall 52. The first sidewall 51 is farther away from the semiconductor substrate 1 than the second sidewall 52. There is an included angle θ between the first sidewall 51 and the second sidewall 52, and the included angle θ is a non-right angle. In some examples, the included angle may be an acute angle. In some examples, the included angle may be an obtuse angle.

In some embodiments, the first notch region 5 is composed of the first sidewall 51 and the second sidewall 52. The first sidewall 51 is close to the P-type conductive region 2, and the second sidewall 52 is close to the gap region 3. The included angle θ between the first sidewall 51 and the second sidewall 52 may be an acute angle, indicating that both the first sidewall 51 and the second sidewall 52 have appropriate lengths, so that the first sidewall 51 and the second sidewall 52 together form a relatively large surface area, which is beneficial to improving the light absorption efficiency of the first notch region 5 for sunlight. The included angle θ between the first sidewall 51 and the second sidewall 52 is measured by a scanning electron microscope (SEM) and/or a transmission electron microscope (TEM). The included angle θ between the first sidewall 51 and the second sidewall 52 refers to the included angle between the interface of the first sidewall 51 and the P-type conductive region 2 and the interface of the second sidewall 52 and the P-type conductive region.

As an example, the included angle θ may be within a range of 30° to 75°, such as 30°, 35°, 40°, 45°, 50°, 55°, 60°, 65°, 70° or 75°. For another example, the include angle θ may be within a range of 92° to 160°, such as 92°, 105°, 110°, 118°, 130°, 135°, 145°, 155° or 160°. Due to the configuration of the included angle, it indicates that there are both a first sidewall 51 with a relatively long length and a second sidewall 52 with a relatively long length, and thus the first notch region 5 has an excellent light-trapping effect. In addition, the sunlight irradiating on the first sidewall 51 can be reflected multiple times between the first sidewall 51 and the second sidewall 52, and the sunlight irradiating on the second sidewall 52 can also be reflected multiple times between the first sidewall 51 and the second sidewall 52, further improving the light utilization efficiency of the first notch region 5 for sunlight. It shall be understood that, the above ranges of the included angle are only some examples, other ranges may also be adopted based on practical requirements.

In some embodiments, a length of the first sidewall 51 is denoted as L1, and a length of the second sidewall 52 is denoted as L2, and a ratio of L1 to L2 is equal to 1:(1~5). For example, the ratio of L1 to L2 may be 1:1, 1:2, 1:3, 1:4 or 1:5. Due to the configuration of the length of the sidewalls, it indicates that the lengths of the first sidewall 51 and the second sidewall 52 have an appropriate proportion, which can utilize more sunlight, and the sunlight can reflect multiple times between the first sidewall 51 and the second sidewall 52 on the rear surface of the semiconductor substrate 1, thereby greatly improving the effective utilization of sunlight. It can be understood that in some embodiments of the present disclosure, the length of the first sidewall 51 may be equal to the length of the second sidewall 52, or the length of the first sidewall 51 may also be less than the length of the second sidewall 52. It shall be understood that, the above ratios of lengths L1 and L2 are only some examples, other ratios may also be adopted based on practical requirements.

In some embodiments, referring to FIG. 4 to FIG. 6, the length of the first sidewall 51 refers to the distance between the intersection line of the second sidewall 52 and the first sidewall 51 and the intersection line of the first sidewall 51 and the second passivation layer 7. The length of the second sidewall 52 refers to the distance between the intersection line of the second sidewall 52 and the semiconductor substrate 1 and the intersection line of the first sidewall 51 and the second sidewall 52. The lengths of the first sidewall 51 and the second sidewall 52 may be directly measured by measuring instruments (such as a scanning electron microscope, a transmission electron microscope, etc.).

In some embodiments, referring to FIG. 6, the first texture structure 501 includes a plurality of first texture substructures a 5011 provided on the first sidewall 51 and a plurality of first texture substructures b 5012 provided on the second sidewall 52. The first texture substructures a 5011 protrude from the surface where the first sidewall 51 is located, and the first texture substructures b 5012 protrude from the surface where the second sidewall 52 is located. In some embodiments, the surface where the first sidewall 51 is located refers to the plane where the interface between the first sidewall 51 and the P-type conductive region 2 is located, and the surface where the second sidewall 52 is located refers to the plane where the interface between the second sidewall 52 and the P-type conductive region 2. When sunlight irradiates on the rear surface of the cell, the protruding first texture substructures a 5011 and first texture substructures b 5012 can absorb sunlight. Moreover, the sunlight irradiating on the first texture substructures a 5011 will be reflected on the surface of the first texture substructures a 5011 and then directed towards the first texture substructures b 5012, and the sunlight irradiating on the first texture substructures b 5012 will be reflected on the surface of the first texture substructures b 5012 and then directed towards the first texture substructures a 5011, so as to improve the effective utilization of sunlight.

In some embodiments, the size of the first texture substructures a 5011 is less than or equal to the size of the first texture substructures b 5012. The above "size" may refer to length, width, height, projection area, volume, etc. The first texture substructures a 5011 and the first texture substructures b 5012 may be set by using at least one of the above means such as length, width, height, projection area and volume. The following takes the size representing length as an example for illustration.

The length of the first texture substructures a 501 is less than or equal to the length of the first texture substructures b 5012. Compared with the first sidewall 51, the second sidewall 52 has even better light absorption effect for sunlight, which is beneficial to improving the photoelectric conversion efficiency of the solar cell. In some embodiments, the length of the first texture substructures a 5011 is less than the length of the first texture substructures b 5012. In some embodiments, different sizes of the first texture structure 501 are designed corresponding to different regions within the first notch region 5, which can improve the light absorption effect of the corresponding regions more targeted and enable the manufactured solar cell to obtain a higher conversion efficiency.

In some embodiments, the height of the first texture substructures a 5011 is within the range of 1 µm to 3 µm. For example, the height may be 1 µm, 1.5 µm, 2 µm, 2.3 µm, 2.8 µm or 3 µm. Due to the configuration of the height of the first texture substructures a 5011, it is beneficial to improving the integrity and uniformity of the film layer on the surface of the first sidewall 51, reducing the internal reflection of light, improving the surface recombination rate of carriers, and thus further improving the photoelectric conversion efficiency and the quality of the solar cell. It can be understood that the first texture substructures a 5011 protrude from the first sidewall 51, and the height of the first texture substructures a 5011 refers to the distance between the top of the first texture substructures a 5011 and the surface where the first sidewall 51 is located.

In some embodiments, the height of the first texture substructures b 5012 is within the range of 1 µm to 3 µm. For example, the height may be 1 µm, 1.5 µm, 2 µm, 2.3 µm, 2.8 µm or 3 µm. Due to the configuration of the height of the first texture substructures b 5012, it is beneficial to improving the integrity and uniformity of the film layer on the surface of the second sidewall 52, reducing the internal reflection of light, improving the surface recombination rate of carriers, and thus further improving the photoelectric conversion efficiency of the solar cell. It can be understood that the first texture substructures b 5012 protrude from the second sidewall 52, and the height of the first texture substructures b 5012 refers to the distance between the top of the first texture substructures b 5012 and the surface where the first sidewall 51 is located.

In some embodiments, the ratio of the total surface area of the first texture substructures a 5011 on the first sidewall 51 to the area of the surface where the first sidewall 51 is located is equal to (1.2~2):1. For example, the ratio may be 1.2:1, 1.4:1, 1.6:1, 1.8:1 or 2:1. Due to the configuration of the total surface area of the first texture substructures a 5011, it indicates that the first sidewall 51 has a relatively large number of first texture substructures a 5011, which can improve the light absorption efficiency of the first sidewall 51 for sunlight. It shall be understood that, the above ratios of surface area are only some examples, other ratios may also be adopted based on practical requirements.

In some embodiments, the ratio of the total surface area of the first texture substructures b 5012 on the second sidewall 52 to the area of the surface where the second sidewall 52 is located is equal to (1.3~2):1. For example, the ratio may be 1.3:1, 1.4:1, 1.5:1, 1.6:1, 1.7:1, 1.8:1, 1.9:1 or 2:1. Due to the configuration of the total surface area of the first texture substructures b 5012, it indicates that the second sidewall 52 has a relatively large number of first texture substructures b 5012, which can improve the light absorption efficiency of the second sidewall 52 for sunlight. It shall be understood that, the above ratios of surface area are only some examples, other ratios may also be adopted based on practical requirements.

In some embodiments, referring to FIG. 5, the first texture substructures a 5011 on the first sidewall 51 have a plurality of first undulating portions. The first undulating portions include first peaks 511 and first valleys 512. The first texture substructures b 5012 on the second sidewall 52 have a plurality of second undulating portions. The second undulating portions include second peaks 521 and second valleys 522. At least part of the first texture substructures a 5011 are located within the second valleys 522, and at least part of the first texture substructures b 5012 are located within the first valleys 512. With such an arrangement, in the first notch region 5, at least part of the first texture substructures a 5011 and the first texture substructures b 5012 are arranged in a staggered manner, so that when sunlight irradiates on the first texture substructures a 5011, the first texture substructures a 5011 can absorb sunlight and the sunlight can also be reflected multiple times between the first texture substructures a 5011 and the first texture substructures b 5012. In addition, when sunlight irradiates on the first texture substructures b 5012, the first texture substructures b 5012 can absorb sunlight and the sunlight can also be reflected multiple times between the first texture substructures a 5011 and the first texture substructures b 5012, thereby further improving the utilization rate of sunlight on the back surface of the cell.

In some embodiments, the projection length D1 of the first sidewall 51 on the plane where the semiconductor substrate 1 is located is within the range of 1 µm to 4 µm. For examples, D1 may be 1 µm, 2 µm, 3 µm or 4 µm.

In some embodiments, the projection length D2 of the second sidewall 52 on the plane where the semiconductor substrate 1 is located is within the range of 4 µm to 6 µm. For examples, D2 may be 4 µm, 4.5 µm, 5 µm, 5.5 µm or 6 µm.

FIG. 7 shows a measurement schematic diagram of a projection length of a first sidewall and a projection length of a second sidewall on the plane of a semiconductor substrate. The projection length D1 of the first sidewall 51 on the plane of the semiconductor substrate 1 refers to the orthographic projection of the first sidewall 51 on the semiconductor substrate 1, and the length of the orthographic projection along the length direction of the semiconductor substrate 1. The projection length D2 of the second sidewall 52 on the plane of the semiconductor substrate 1 refers to the orthographic projection of the second sidewall 52 on the semiconductor substrate 1, and the length of the orthographic projection along the length direction of the semiconductor substrate 1.

In some embodiments, a distribution proportion of the first notch region 5 on the rear surface of the semiconductor substrate 1 is within a range of 0.5% to 1.5%. For example, the proportion may be 0.5%, 0.8%, 1%, 1.2% or 1.5%.

It can be understood that by limiting the projection lengths of the first sidewall 51 and the second sidewall 52 of the first notch region 5 on the plane of the semiconductor substrate 1 and the distribution proportion of the first notch region 5 on the rear surface of the semiconductor substrate 1, a PN junction with excellent conductivity can be formed on the semiconductor substrate 1 during the manufacturing process of the solar cell, thereby improving the photoelectric performance of the prepared solar cell.

In some embodiments, referring to FIG. 6, the second passivation layer 7 has a second notch region 701 recessed along the first direction, and the second notch region 701 corresponds to the position of the first notch region 5. It can be understood that since the second passivation layer 7 is provided on the rear surface of the semiconductor substrate 1, it will also be provided on the surfaces of the P-type conductive region 2 and the gap region 3. In this way, the second passivation layer 7 will also form second notch region 701 in the region corresponding to the first notch region 5. The second notch region 701 has a third sidewall 71 and a fourth sidewall 72, and the third sidewall 71 is farther away from the semiconductor substrate 1 than the fourth sidewall 72. In some examples, an included angle between the third sidewall 71 and the fourth sidewall 72 may be an acute angle, which can form good passivation for the second notch region 701. In other examples, the included angle may be an obtuse angle.

Next, in combination with the drawings in the embodiments of the present disclosure, the manufacturing method of the solar cell 100 in the present disclosure will be clearly and completely described. The described embodiments are only some of the embodiments of the present disclosure, rather than all of them.

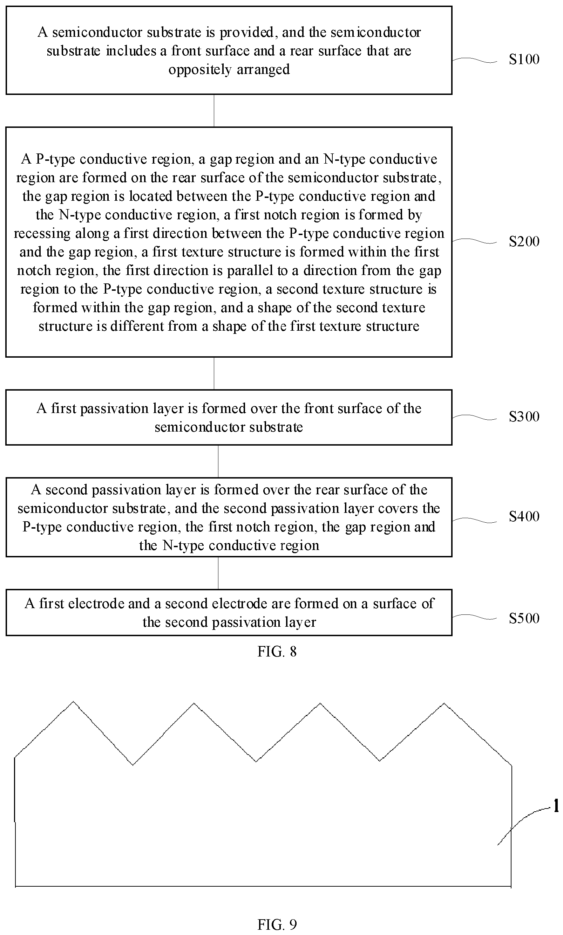

FIG. 8 shows a flow chart of a method for manufacturing solar cell according to one or more embodiments of the present disclosure. As shown in FIG. 8, the manufacturing method includes: providing a semiconductor substrate 1, the semiconductor substrate 1 includes a front surface and a rear surface that are oppositely arranged; forming a P-type conductive region 2, a gap region 3 and an N-type conductive region 4 on the rear surface of the semiconductor substrate 1, the gap region 3 is located between the P-type conductive region 2 and the N-type conductive region 4, a first notch region 5 is formed between the P-type conductive region 2 and the gap region 3 by recessing along a first direction, a first texture structure 501 is provided within the first notch region 5, the first direction is parallel to a direction from the gap region 3 pointing to the P-type conductive region 2, a second texture structure 31 is provided within the gap region 3, and a shape of the second texture structure 31 is different from a shape of the first texture structure 501; forming a first passivation layer 6 on the front surface of the semiconductor substrate 1; forming a second passivation layer 7 on the rear surface of the semiconductor substrate 1, the second passivation layer 7 covers the P-type conductive region 2, the first notch region 5, the gap region 3 and the N-type conductive region 4; forming a first electrode 8 on a surface of the second passivation layer 7; and forming a second electrode 9 on a surface of the second passivation layer 7.

In some embodiments, by forming a first notch region 5 recessing along the first direction in the region between the P-type conductive region 2 and the gap region 3 on the rear surface of the semiconductor substrate 1, the first notch region 5 recessing along the first direction can increase the effective area for light absorption of the solar cell, solving the problem that a "step " or "slope " shape region between the P-type conductive region 2 and the gap region 3 on the back surface of the solar cell in the related art fails to bring efficiency gains to the solar cell. The shape of the first texture structure 501 within the first notch region 5 is different from that of the second texture structure 31 within the gap region 3, the second texture structure 31 usually has a pyramidal shape. The first texture structure 501 in some embodiments of the present disclosure has a non-pyramidal shape. The first texture structure 501 in the first notch region 5 has good light-trapping effect and can increase the surface area of the rear surface of the semiconductor substrate 1, thereby increasing the light absorption of sunlight on the back surface and reducing the reflection of sunlight on the back surface. Moreover, the long-wavelength light passing through the semiconductor substrate 1 from the front side of the cell can also be absorbed by the first texture structure 501, further increasing the overall light absorption efficiency of the cell. In addition, it will not affect the passivation effect of the region between the P-type conductive region 2 and the gap region 3, thereby improving the photoelectric conversion efficiency of the solar cell.

S100, a semiconductor substrate 1 is provided. The semiconductor substrate 1 includes a front surface and a rear surface that are oppositely arranged. The structural schematic diagram of the semiconductor substrate 1 is shown in FIG. 9.

In some embodiments, the front surface of the semiconductor substrate 1 corresponds to the front side of the cell. The front side of the cell is the surface facing the sun (i.e., the light-receiving surface). The rear surface of the semiconductor substrate 1 corresponds to the back side of the cell. The back side of the cell is the surface facing away from the sun (i.e., the backlight surface).

In some embodiments, the semiconductor substrate 1 is an N-type crystalline silicon substrate (or silicon wafer), and it may also be a P-type crystalline silicon substrate (silicon wafer). The crystalline silicon substrate is, for example, one of a polycrystalline silicon substrate, a monocrystalline silicon substrate, a microcrystalline silicon substrate or a silicon carbide substrate. Embodiments of the present disclosure do not limit the specific type of the semiconductor substrate 1.

In some embodiments, the thickness of the semiconductor substrate 1 is within the range of 60 µm to 240 µm. For example, the thickness may be 60 µm, 80 µm, 90 µm, 100 µm, 120 µm, 150 µm, 200 µm or 240 µm, etc., which is not limited here.

S200, a P-type conductive region 2, a gap region 3 and an N-type conductive region 4 are formed on the rear surface of the semiconductor substrate 1. The gap region 3 is located between the P-type conductive region 2 and the N-type conductive region 4. There is a first notch region 5 recessed along a first direction between the P-type conductive region 2 and the gap region 3. A first texture structure 501 is formed within the first notch region 5, the first direction is parallel to a direction from the gap region 3 pointing to the P-type conductive region 2. A second texture structure 31 is formed within the gap region 3, and a shape of the second texture structure 31 is different from a shape of the first texture structure 501.

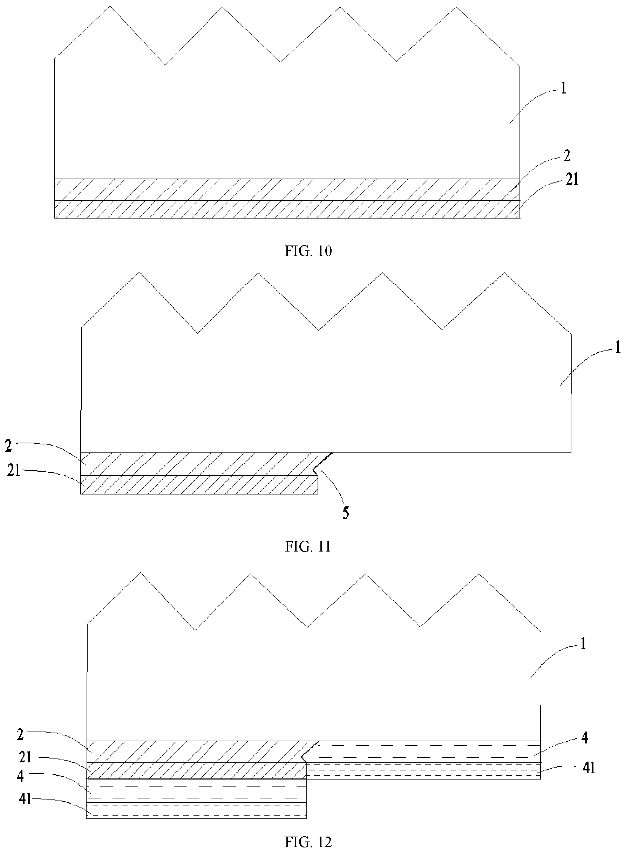

S201, a first diffusion treatment is performed on the rear surface of the semiconductor substrate 1 to obtain a first pre-treatment region. The obtained structure is shown in FIG. 10.

In this step, the first diffusion treatment is a diffusion treatment performed on the entire rear surface of the semiconductor substrate 1. A doping source for the first diffusion treatment includes a P-type conductive doping source. In some embodiments, the doping source for the first diffusion treatment may be, for example, a boron source. The first diffusion treatment may diffuse boron atoms through the boron source to form a boron diffusion layer (i.e., the P-type conductive region 2). The boron source may be, for example, boron tribromide, etc. Since the surface of the semiconductor substrate 1 has a relatively high concentration of boron, a borosilicate glass layer (BSG) 21 is usually obtained. This borosilicate glass layer 21 has a metal impurities absorption effect and will adversely affect the normal working of the solar cell, so it needs to be removed in the subsequent process.

In some embodiments, the first diffusion treatment may adopt any one or more methods among high-temperature diffusion, slurry doping or ion implantation. The following takes high-temperature diffusion as an example to describe the process of the first diffusion treatment.

In some embodiments, the temperature of the first diffusion treatment is within the range of 800 °C to 1200 °C. For example, the temperature may be 800 °C, 850 °C, 900 °C, 950 °C, 1000 °C, 1100 °C or 1200 °C.

In some embodiments, the time of the first diffusion treatment is within the range of 2 h to 5 h. For example, the time may be 2 h, 3 h, 4 h or 5 h.

In some embodiments, the first diffusion treatment forms a borosilicate glass layer 21 on the surface of the first pre-treatment region. The thickness of the borosilicate glass layer 21 is within the range of 100 nm to 200 nm. For example, the thickness may be 100 nm, 110 nm, 130 nm, 150 nm, 180 nm or 200 nm.

S202, a first local laser treatment and first etching treatment are performed on the first pre-treatment region. The obtained structure is shown in FIG. 11.

In this step, by performing the local laser treatment on the first pre-treatment region, parts of the boron diffusion layer and the borosilicate glass layer 21 in S201 are etched, and the semiconductor substrate 1 is exposed. The regions that are not treated by the laser remain as the P-type conductive region 2 and the borosilicate glass layer 21. It can be understood that during the laser treatment process, the semiconductor materials are prone to thermal melting damage and thermal stress damage caused by the laser, so the first etching treatment is used to remove the thermal damage generated by the first local laser treatment.

In some embodiments, the laser power of the first local laser treatment is within the range of 20 W to 30 W. For example, the laser power may be 20 W, 22 W, 25 W, 28 W or 30 W.

In some embodiments, the etching width of the first local laser treatment is within the range of 300 µm to 600 µm. For example, the etching width may be 300 µm, 350 µm, 400 µm, 450 µm, 500 µm, 560 µm or 600 µm.

In some embodiments, the etching agent for the first etching treatment includes an alkaline substance and a treatment agent. The treatment agent includes at least one of a texturing additive and an alkaline polishing additive. The alkaline substance may be, for example, sodium hydroxide. The texturing additive and/or the alkaline polishing additive mainly include isopropyl alcohol, surfactants, defoaming agents, sodium acetate, potassium sorbate and deionized water, etc. The texturing additive and/or the alkaline polishing additive used in the present disclosure are common reagents used in the field of etching, and the specific components are not limited here. The texturing additive may improve the hydrophilicity of the texturing solution on the surface of the semiconductor substrate 1, accelerate the detachment of bubbles on the surface of the semiconductor substrate 1, remove oil stains on the surface of the semiconductor substrate 1, and control the corrosion rate of the semiconductor substrate 1 in the alkaline solution. Based on the similar principle, the alkaline polishing additive may also control the corrosion rate of the semiconductor substrate 1 in the alkaline solution. In some embodiments of the present disclosure, by adding the texturing additive and/or the alkaline polishing additive to the alkaline substance, the anisotropy of the material etching in the P-type conductive region 2 is controlled to obtain the first notch region 5 recessed along the first direction, thereby improving the light utilization efficiency of the cell.

In some embodiments, the mass ratio of the alkaline substance to the treatment agent is equal to (2~6):1. For example, the mass ratio may be 2:1, 3:1, 4:1, 5:1 or 6:1, etc. Due to the configuration of the mass ratio of the alkaline substance to the treatment agent, the direction and rate of the first etching treatment can be controlled, the etching along the thickness direction of the semiconductor substrate 1 can be reduced, and the etching along the length or width direction of the semiconductor substrate 1 can be increased, so that the first notch region 5 is formed at the edge of the P-type conductive region 2. The first notch region 5 has a first sidewall 51 and a second sidewall 52, the first sidewall 51 is farther away from the semiconductor substrate 1 than the second sidewall 52, and the first notch region 5 is provided with a first texture structure 501.

In some embodiments, the sizes of the first sidewall 51 and the second sidewall 52 are controlled by controlling the mass ratio of the alkaline substance to the treatment agent. It shall be understood that, the above mass ratios are only some examples, other mass ratios may also be adopted based on practical requirements.

In some embodiments, the size of the first texture structure 501 in the first sidewall 51 and the second sidewall 52 is controlled by controlling the mass ratio of the alkaline substance to the treatment agent. The first sidewall 51 has the first texture substructures a 5011, and the second sidewall 52 has the first texture substructures b 5012. As the amount of the treatment agent added increases, the sizes of the first texture substructures a 5011 and the first texture substructures b 5012 gradually increase. However, if the sizes of the first texture substructures a 5011 and the first texture substructures b 5012 are too large, the number of the first texture structures 501 provided on the first sidewall 51 and the second sidewall 52 will be relatively small. Therefore, in some embodiments of the present disclosure, by controlling the mass ratio of the alkaline substance to the treatment agent to be (2~6):1, a balance can be achieved among the sizes of the first sidewall 51 and the second sidewall 52 and the first texture structures 501 on the first sidewall 51 and the second sidewall 52, thereby effectively improving the utilization rate of sunlight by the P-type conductive region 2.

In some embodiments, the time of the first etching treatment is within the range of 500 s to 1000 s. For example, the time may be 500 s, 600 s, 700 s, 800 s, 900 s or 1000 s. Due to the configuration of the time of the first etching treatment, it is conducive to forming the first sidewall 51, the second sidewall 52 and the first texture structure 501 on the first sidewall 51 and the second sidewall 52 with an appropriate size, which is beneficial to improving the utilization rate of sunlight on the back side of the cell.

In some embodiments, by controlling the etching agent and the etching treatment of the first etching treatment, the first sidewall 51 and the second sidewall 52 in the first notch region 5 may have certain structures, and the first texture structure 501 may have a certain shape on the first sidewall 51 and the second sidewall 52. This can reduce the utilization rate of the incident light on the back side of the semiconductor substrate 1, increase the light absorption of the long-wavelength light on the front side of the semiconductor substrate 1, improve the light utilization efficiency of the solar cell. In addition, it will not affect the passivation effect of the region between the P-type conductive region 2 and the gap region 3, thereby improving the photoelectric conversion efficiency of the solar cell.

S203, a second diffusion treatment is performed on the rear surface of the semiconductor substrate 1 to obtain a second pre-treatment region. The obtained structure is shown in FIG. 12.

In some embodiments, a doping source for the second diffusion treatment includes an N-type conductive doping source. In some embodiments, the doping source for the second diffusion treatment may be, for example, a phosphorus source. The second diffusion treatment may diffuse phosphorus atoms through the phosphorus source to form a phosphorus diffusion layer (i.e., the N-type conductive region 4). The phosphorus source may be, for example, POCl₃, etc. Since the surface of the semiconductor substrate 1 has a relatively high concentration of phosphorus, a phosphosilicate glass layer (PSG) 41 is usually formed. This phosphosilicate glass layer 41 has a metal impurities absorption effect and will adversely affect the normal working of the solar cell, so it needs to be removed in the subsequent process.

In this step, by performing the second diffusion treatment on the rear surface of the semiconductor substrate 1, in the region on the rear surface of the semiconductor substrate 1 that have not undergone the first local laser treatment, the rear surface of the semiconductor substrate 1 is successively provided with the P-type conductive region 2, the borosilicate glass layer 21, the N-type conductive region 4 and the phosphosilicate glass layer 41. In the region on the rear surface of the semiconductor substrate 1 that have undergone the first local laser treatment, the rear surface of the semiconductor substrate is successively provided with the N-type conductive region 4 and the phosphosilicate glass layer 41.

In some embodiments, the second diffusion treatment may adopt any one or more methods among high-temperature diffusion, slurry doping or ion implantation.

The following takes high-temperature diffusion as an example to describe the process of the second diffusion treatment.

The temperature of the second diffusion treatment is within the range of 700 °C to 1000 °C. For example, the temperature may be 700 °C, 750 °C, 800 °C, 830 °C, 890 °C, 950 °C or 1000 °C.

In some embodiments, the time of the second diffusion treatment is within the range of 1 h to 3 h. For example, the time may be 1 h, 1.5 h, 2 h, 2.5 h or 3 h.

In some embodiments, the thickness of the phosphosilicate glass layer 41 is within the range of 100 nm to 200 nm. For example, the thickness may be 100 nm, 110 nm, 130 nm, 150 nm, 180 nm or 200 nm.

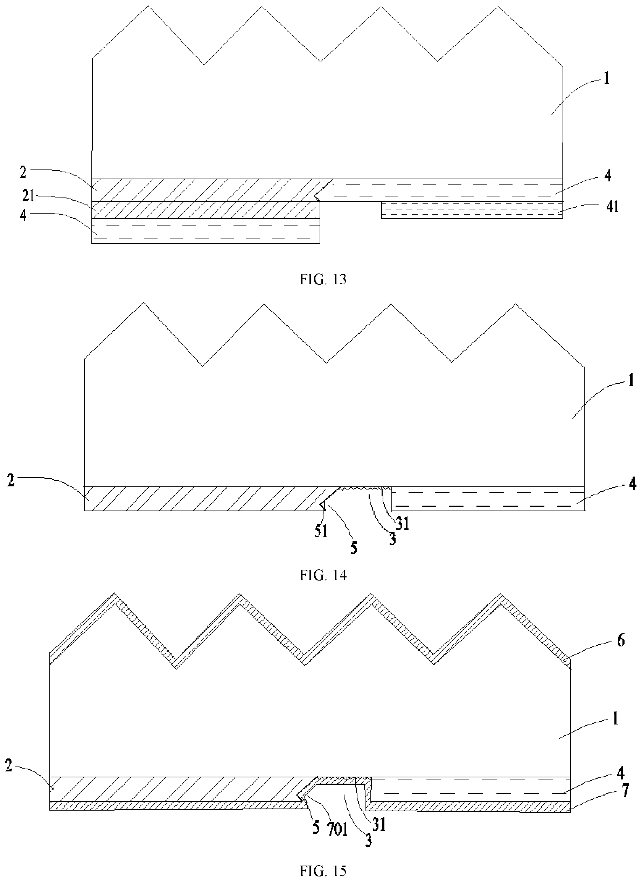

S204, a second local laser treatment and a second etching treatment are performed on the second pre-treatment region, so that the second pre-treatment region forms the P-type conductive region 2, the gap region 3 and the N-type conductive region 4. The gap region 3 is located between the P-type conductive region 2 and the N-type conductive region 4, and there is a first notch region 5 recessed along the first direction between the gap region 3 and the P-type conductive region 2, and a first texture structure 501 is formed within the first notch region 5. The obtained structure is shown in FIG. 14.

In this step, the region for the second local laser treatment are the region that have undergone the first local laser treatment in Step 202 and part of region that have not undergone the first local laser treatment. Through the second local laser treatment, the phosphosilicate glass layer 41 in the region that have undergone the first local laser treatment is removed, and the phosphosilicate glass layer 41 in the part of the region that have not undergone the first local laser treatment is removed. The obtained structure is shown in FIG. 13. Then, the second etching treatment is carried out to etch away the borosilicate glass layer 21 and the N-type conductive region 4 in the region that have undergone the first local laser treatment, and in addition, to etch away the phosphosilicate glass layer 41 and part of the N-type conductive region 4 in the part of the region that have not undergone the first local laser treatment, so that the rear surface of the semiconductor substrate 1 is composed of the P-type conductive region 2, the gap region 3 and the N-type conductive region 4. The gap region 3 is provided between the P-type conductive region 2 and the N-type conductive region 4, and the first notch region 5 between the P-type conductive region 2 and the gap region 3 is exposed.

In some embodiments, the laser power of the second local laser treatment is within the range of 20 W to 30 W. For example, the laser power may be 20 W, 22 W, 25 W, 28 W or 30 W.

In some embodiments, the etching width of the second local laser treatment is within the range of 400 µm to 700 µm. For example, the etching width may be 400 µm, 450 µm, 500 µm, 550 µm, 600 µm, 650 µm or 700 µm. It can be understood that the etching width of the second local laser treatment is greater than the etching width of the first local laser treatment.

In some embodiments, the etching agent for the second etching treatment includes an alkaline solution. For example, the alkaline solution may be a sodium hydroxide solution.

In some embodiments, the concentration of the alkaline solution is within the range of 0.5% to 5%. For example, the concentration may be 0.5%, 1%, 1.8%, 2.5%, 3.2%, 3.5%, 4%, 4.5% or 5%.

In some embodiments, the temperature of the second etching treatment is within the range of 60 °C to 80 °C. For example, the temperature may be 60 °C, 63 °C, 68 °C, 73 °C, 77 °C or 80 °C.

In some embodiments, the time of the second etching treatment is within the range of 300 s to 800 s. For example, the time may be 300 s, 400 s, 500 s, 600 s, 700 s or 800 s.

In some embodiments, by using certain etching agent to perform the first etching treatment after the first local laser treatment, the first notch region 5 with a certain shape and structure is pre-formed in the region of the P-type conductive region 2 close to the gap region 3. The first notch region 5 has a first texture structure 501, which can reduce the reflection of the incident light on the back side of the semiconductor substrate 1, and increase the reflection of the long-wavelength light on the front side of the semiconductor substrate 1, thereby improving the light utilization efficiency of the solar cell. In addition, it will not affect the passivation effect of the region between the P-type conductive region 2 and the gap region 3, thereby improving the photoelectric conversion efficiency of the solar cell.

It can be understood that since the second etching treatment is carried out after the second diffusion treatment, a third notch region is formed in the region between the gap region 3 and the N-type conductive region 4. The shape of the third notch region is a conventional shape, that is, a "step" or "slope" shape. The notch region with the above morphologies cannot effectively utilize sunlight and cannot effectively improve the photoelectric conversion efficiency of the cell.

S300, a first passivation layer 6 is formed on the front surface of the semiconductor substrate 1.

In some embodiments, by forming the first passivation layer 6 on the front surface of the semiconductor substrate 1, the first passivation layer 6 can utilize the passivation effect to reduce the minority carrier concentration on the surface of the semiconductor substrate 1, and suppress the carrier recombination on the surface of the cell, thereby reducing the surface recombination rate. In addition, it can also reduce the series resistance and improve the electron transport ability.

In some embodiments, the first passivation layer 6 may include, but is not limited to, a single oxide layer such as silicon oxide, silicon nitride, silicon oxynitride, aluminium oxide or a multi-layer structure. It is understandable that, other types of passivation layers may also be used. The present disclosure does not limit the specific material of the first passivation layer 6. The above-mentioned first passivation layer 6 can have a good passivation and anti-reflection effect on the semiconductor substrate 1 and is helpful for improving the conversion efficiency of the cell.

In some embodiments, the thickness of the first passivation layer 6 is within the range of 10 nm to 100 nm. For example, the thickness may be 10 nm, 20 nm, 30 nm, 42 nm, 50 nm, 60 nm, 70 nm, 80 nm, 90 nm or 100 nm, etc. It is understandable that, it may also be other values within the above range, which is not limited here.

In some embodiments, the manufacturing method of the present disclosure further includes forming an anti-reflection layer on the surface of the first passivation layer 6 to reduce the light reflection on the front surface of the cell.

In some embodiments, the anti-reflection layer may be, for example, a silicon oxynitride layer, or it may also be an aluminium oxide/silicon nitride stacked structure, which is not limited by the present disclosure. Taking the silicon oxynitride layer as an example, the silicon oxynitride can effectively reduce the light reflection and improve the light transmittance. By controlling the thickness of the film, its reflectivity can be adjusted to achieve the desired anti-reflection effect. Moreover, the raw material NH₄ of silicon oxynitride will decompose into H atoms during the reaction process, and the H atoms will permeate into the semiconductor substrate 1 under high temperature and combine with the dangling bonds on the surface to achieve the passivation effect.

In some embodiments, the thickness of the first passivation layer 6 is within the range of 40 nm to 100 nm. For example, the thickness may be 40 nm, 50 nm, 60 nm, 70 nm, 80 nm, 90 nm or 100 nm, etc. It is understandable that, it may also be other values within the above range, which is not limited here.

In some embodiments, the plasma enhanced chemical vapor deposition method may be used to deposit the first passivation layer 6 and/or the anti-reflection layer. It is understandable that, other methods may also be used, such as the organic chemical vapor deposition method, etc. Embodiments of the present disclosure do not limit the specific implementation manner of the first passivation layer 6.

S400, a second passivation layer 7 is formed on the rear surface of the semiconductor substrate 1. The second passivation layer 7 covers the P-type conductive region 2, the first notch region 5, the gap region 3 and the N-type conductive region 4. The obtained structure is shown in FIG. 15.

Referring to FIG. 15 and FIG. 4, since the formed second passivation layer 7 covers the first notch region 5 between the P-type conductive region 2 and the gap region 3, the second passivation layer 7 has a second notch region 701 corresponding to the first notch region 5. The second notch region 701 includes a third sidewall 71 and a fourth sidewall 72. There is an included angle between the third sidewall 71 and the fourth sidewall 72. In some examples, the included angle may be an acute angle. In some other examples, the included angle may be an obtuse angle. Due to the configuration of the included angle, the second passivation layer 7 can completely cover the first notch region 5 and improve the passivation effect on the back side of the cell. It can be understood that the surface of the second passivation layer 7 is a smooth structure, which can fill the first valleys 512 and the second valleys 522 of the first texture substructures.

In some embodiments, the second passivation layer 7 includes any one or a combination of a silicon nitride layer, a silicon oxynitride layer, and an aluminium oxide/silicon nitride stacked structure. It is understandable that, the second passivation layer 7 may also adopt other types of passivation layers. The present disclosure does not limit the specific material of the second passivation layer 7. For example, in some other embodiments, the second passivation layer 7 may also be a stacked structure of silicon dioxide and silicon nitride, etc. The above-mentioned second passivation layer 7 can have a good passivation effect on the silicon substrate and is helpful for improving the conversion efficiency of the cell.

In some embodiments, the plasma enhanced chemical vapor deposition method may be used to deposit the second passivation layer 7. It is understandable that, other methods may also be used, such as the organic chemical vapor deposition method, etc.

In some embodiments, the thickness range of the second passivation layer 7 is from 10 nm to 100 nm. For example, the thickness may be 10 nm, 20 nm, 30 nm, 42 nm, 50 nm, 60 nm, 70 nm, 80 nm, 90 nm or 100 nm, etc. It is understandable that, it may also be other values within the above range, which is not limited here.

S500, a first electrode 8 and a second electrode 9 are formed on the surface of the second passivation layer 7 to obtain the solar cell 100. The structural schematic diagram of the solar cell 100 is shown in FIG. 3.

For example, in this step, by performing the metallization treatment on the surface of the second passivation layer 7, the first electrode 8 and the second electrode 9 are obtained. The first electrode 8 and the second electrode 9 correspond to the P-type conductive region 2 and the N-type conductive region 4, respectively. The first electrode 8 and the second electrode 9 can be formed by the screen printing method and then sintered, so that the first electrode 8 penetrates the second passivation layer 7 to form an ohmic contact with the N-type conductive region 4, and the second electrode 9 penetrates the second passivation layer 7 to form an ohmic contact with the P-type conductive region 2. Alternatively, the first electrode 8 penetrates the second passivation layer 7 to form an ohmic contact with the P-type conductive region 2, and the second electrode 9 penetrate the second passivation layer 7 to form an ohmic contact with the N-type conductive region 4. It is understandable that, at least one of the metal evaporation method and the electroplating method may also be used to form the first electrode 8 and the second electrode 9 on the rear surface of the cell.

It should be noted that the specific materials of the first electrode 8 and the second electrode 9 are not limited in the embodiments of the present disclosure. For example, when the first electrode 8 forms an ohmic contact with the P-type conductive region 2 and the second electrode 9 forms an ohmic contact with the N-type conductive region 4, the first electrode 8 is a silver electrode or a silver/aluminium electrode, and the second electrode 9 is a silver electrode. For example, silver paste may be printed on the lower surface of the second passivation layer 7 corresponding to the N-type conductive region 4, and silver paste or silver/aluminium paste doped with a small amount of aluminium may be printed on the lower surface of the second passivation layer 7 corresponding to the P-type conductive region 2. After being sintered, the paste may be burned to penetrate the second passivation layer 7, and the formed silver electrode or silver/aluminium electrode forms an ohmic contact with the P-type conductive region 2, and the formed silver electrode forms an ohmic contact with the N-type conductive region 4.

It should be noted that in the present disclosure, unless otherwise specified, each operation step may be carried out in sequence or not in sequence. Embodiments of the present disclosure do not limit the sequence of steps for preparing the solar cell, and it may be adjusted according to the actual production process.

The solar cell may be an N-type IBC cell or a P-type IBC cell.

Embodiments of the present disclosure also provide a photovoltaic module 1000, which includes at least one solar cell string formed by electrically connecting the aforementioned solar cells.

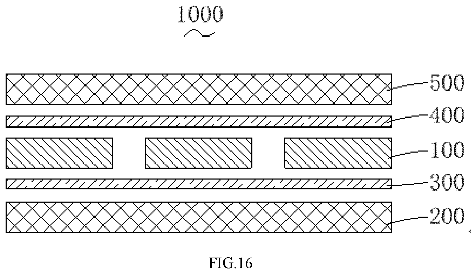

For example, referring to FIG. 16, the photovoltaic module 1000 includes a first cover plate 200, a first encapsulation adhesive layer 300, at least one solar cell string, a second encapsulation adhesive layer 400 and a second cover plate 500.

In some embodiments, the solar cell string includes a plurality of solar cells 100 as described above that are connected by conductive strips. The way of connecting the solar cells 100 may be partial stacking or splicing.

In some embodiments, the first cover plate 200 and the second cover plate 500 may be transparent or non-transparent cover plates, such as glass cover plates or plastic cover plates.

Both sides of the first encapsulation adhesive layer 300 are respectively in contact and attached to the first cover plate 200 and the solar cell string, and both sides of the second encapsulation adhesive layer 400 are respectively in contact and attached to the second cover plate 500 and the solar cell string. The first encapsulation adhesive layer 300 and the second encapsulation adhesive layer 400 may respectively be ethylene-vinyl acetate copolymer (EVA) film, polyethylene octene copolymer elastomer (POE) film or polyethylene terephthalate (PET) film.

The photovoltaic module 1000 may also adopt side full-enclosure encapsulation, that is, encapsulation tapes are used to fully cover and encapsulate the sides of the photovoltaic module 1000 to prevent the photovoltaic module 1000 from experiencing the phenomenon of lamination deviation during the lamination process.

The photovoltaic module 1000 also includes an edge-sealing component, which is fixedly encapsulated on part of the edges of the photovoltaic module 1000. The edge-sealing component may be fixedly encapsulated on the edges near the corners of the photovoltaic module 1000. The edge-sealing component may be a high-temperature-resistant tape. The high-temperature-resistant tape has relatively excellent high-temperature-resistant characteristics and will not decompose or fall off during the lamination process, and can ensure the reliable encapsulation of the photovoltaic module 1000. Both ends of the high-temperature-resistant tape are respectively fixed to the second cover plate 500 and the first cover plate 200. Both ends of the high-temperature-resistant tape may be respectively bonded to the second cover plate 500 and the first cover plate 200, while its middle part can limit the sides of the photovoltaic module 1000 to prevent the photovoltaic module 1000 from undergoing lamination deviation during the lamination process.

The above descriptions are only preferred embodiments of the present disclosure and are not intended to limit the present disclosure. The scope of the present disclosure shall be defined by the appended claims.

## Claims

1. A solar cell, comprising:
a semiconductor substrate including a front surface and a rear surface opposite to the front surface, wherein P-type conductive regions and N-type conductive regions are arranged in an alternating manner on the rear surface of the semiconductor substrate, and gap regions are each formed between adjacent P-type conductive region and N-type conductive region, a first notch region is formed by recessing along a first direction between the P-type conductive region and the gap region, a first texture structure is formed within the first notch region, the first direction is parallel to a direction from the gap region to the P-type conductive region, a second texture structure is formed within the gap region, and a shape of the second texture structure is different from a shape of the first texture structure;
a first passivation layer formed over the front surface of the semiconductor substrate;
a second passivation layer formed over the rear surface of the semiconductor substrate, wherein the second passivation layer covers the P-type conductive regions, the first notch regions, the gap regions and the N-type conductive regions;
a first electrode penetrating the second passivation layer to form an ohmic contact with the P-type conductive region; and
a second electrode penetrating the second passivation layer to form an ohmic contact with the N-type conductive region.

2. The solar cell according to claim 1, wherein the first notch region includes a first sidewall and a second sidewall, the first sidewall is farther away from the semiconductor substrate than the second sidewall, an included angle is formed between the first sidewall and the second sidewall, and the included angle is a non-right angle.

3. The solar cell according to claim 2, wherein the included angle is an acute angle.

4. The solar cell according to claim 2, wherein a length of the first sidewall is denoted as **L1,** and a length of the second sidewall is denoted as L2, and a ratio of L1 to L2 is 1:(1~5).

5. The solar cell according to claim 2, wherein the first texture structure includes a plurality of first texture substructures *a* formed on the first sidewall and a plurality of first texture substructures *b* formed on the second sidewall, the first texture substructures *a* protrude from a surface of the first sidewall, and the first texture substructures b protrude from a surface of the second sidewall.

6. The solar cell according to claim 5, wherein a dimension of the first texture substructure *a* is less than or equal to a dimension of the first texture substructure *b.*

7. The solar cell according to claim 5, wherein a height of the first texture substructure *a* is within a range of 1 µm to 3 µm, and/or a height of the first texture substructure b is within a range of 1 µm to 3 µm.

8. The solar cell according to claim 5, wherein a ratio of a total surface area of the first texture substructures *a* on the first sidewall to an area of the surface of the first sidewall is **(1.2~2):1,** and/or a ratio of a total surface area of the first texture substructures b on the second sidewall to an area of the surface of the second sidewall is (1.3~2):1.

9. The solar cell according to claim 5, wherein a shape of the first texture substructure *a* and/or a shape of the first texture substructure b comprise at least one of a prismatic shape, a pyramidal shape or a pencil-like shape.

10. The solar cell according to claim 5, wherein the first texture substructures *a* on the first sidewall include a plurality of first undulating portions, and the first undulating portions include first peaks and first valleys, the first texture substructures b on the second sidewall include a plurality of second undulating portions, and the second undulating portions include second peaks and second valleys; and
wherein at least part of the first texture substructures *a* is located within the second valleys, and at least part of the first texture substructures b is located within the first valleys.

11. The solar cell according to claim 2, wherein a length of a projection of the first sidewall on the plane of the semiconductor substrate is within a range of 1 µm to 4 µm, and/or a length of a projection of the second sidewall on the plane of the semiconductor substrate is within a range of 4 µm to 6 µm, and/or a distribution proportion of the first notch region on the rear surface of the semiconductor substrate is within a range of 0.5% to 1.5%.

12. The solar cell according to claim **1,** wherein the second passivation layer includes a second notch region formed by recessing along the first direction corresponding to a position of the first notch region, the second notch region has a third sidewall and a fourth sidewall, the third sidewall is farther away from the semiconductor substrate than the fourth sidewall, and an included angle between the third sidewall and the fourth sidewall is a non-right angle.

13. A method for manufacturing solar cell, comprising:
providing a semiconductor substrate, wherein the semiconductor substrate comprises a front surface and a rear surface opposite to the front surface;
forming P-type conductive regions, gap regions and N-type conductive regions on the rear surface of the semiconductor substrate, wherein the gap regions are each provided between adjacent P-type conductive region and N-type conductive region, a first notch region is formed by recessing along a first direction between the P-type conductive region and the gap region, a first texture structure is formed within the first notch region, the first direction is parallel to a direction from the gap region to the P-type conductive region, a second texture structure is formed within the gap region, and a shape of the second texture structure is different from a shape of the first texture structure;
forming a first passivation layer over the front surface of the semiconductor substrate;
forming a second passivation layer over the rear surface of the semiconductor substrate, wherein the second passivation layer covers the P-type conductive regions, the first notch regions, the gap regions and the N-type conductive regions; and
forming a first electrode and a second electrode on a surface of the second passivation layer.

14. The method according to claim 13, wherein forming the first notch region comprises:
performing a first diffusion treatment on the rear surface of the semiconductor substrate to obtain a first pre-treatment region, wherein a doping source for the first diffusion treatment includes a P-type conductive doping source;
performing a first local laser treatment and a first etching treatment on the first pre-treatment region, wherein an etching agent for the first etching treatment includes an alkaline substance and a treatment agent, the treatment agent includes at least one of a texturing additive or an alkaline polishing additive, and a mass ratio of the alkaline substance to the treatment agent is (2~6):1;
performing a second diffusion treatment on the rear surface of the semiconductor substrate to obtain a second pre-treatment region, wherein a doping source for the second diffusion treatment includes an N-type conductive doping source; and
performing a second local laser treatment and a second etching treatment on the second pre-treatment region.

15. A photovoltaic module, comprising: at least one cover plate, at least one encapsulation material layer and at least one solar cell string, wherein the at least one solar cell string comprises a plurality of solar cells according to any one of claims 1-12 or manufactured by the method according to any one of claims 13-14.
